# EUROPÄISCHE PATENTSCHRIFT

(11) **EP 1 339 107 B1**
(45) Veröffentlichungstag und Bekanntmachung des Hinweises auf die Patenterteilung: **30.11.2011**
(21) Anmeldenummer: 02004148.9
(22) Anmeldetag: 25.02.2002
(51) Int. Cl.: H01L 29/788

(54) **Feldeffekttransistor**
Field effect transistor
Transistor à effet de champ

(43) Veröffentlichungstag der Anmeldung: 27.08.2003
(73) Patentinhaber: Infineon Technologies AG, 85579 Neubiberg (DE)
(72) Erfinder: Baumgartner, Peter, Dr., 80331 München (DE)
(74) Vertreter: Repkow, Ines

(56) Entgegenhaltungen:
- WO-A-01/67517
- US-A- 5 264 719
- PATENT ABSTRACTS OF JAPAN vol. 010, no. 046 (E-383), 22. Februar 1986 (1986-02-22) -& JP 60 200573 A (TOSHIBA KK), 11. Oktober 1985 (1985-10-11)

## Beschreibung

Die vorliegende Erfindung betrifft eine Vorrichtung gemäß dem Oberbegriff des Patentanspruchs 1, d.h. einen Feldeffekttransistor mit einem Source-Abschnitt, einem Drain-Abschnitt, und einem Gate-Abschnitt.

Feldeffekttransistoren (FETs) sind seit vielen Jahren in unzähligen Ausführungsformen bekannt und bedürfen keiner näheren Erläuterung.

Feldeffekttransistoren werden beispielsweise, aber bei weitem nicht ausschließlich in Speichereinrichtungen zum Speichern von Daten eingesetzt.

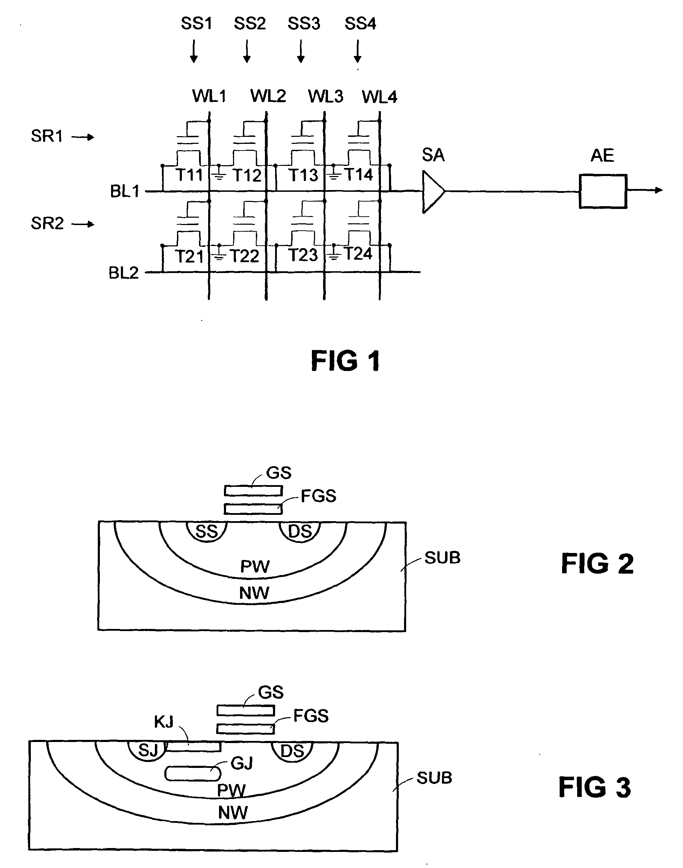

In Figur 1 ist beispielhaft eine solche Speichereinrichtung dargestellt.

Die in der Figur 1 gezeigte Speichereinrichtung ist ein Flash-Speicher, und enthält eine Vielzahl von in einer Vielzahl von Reihen und in einer Vielzahl von Spalten angeordneten Speicherzellen, wobei die Speicherzellen jeweils durch einen Speichertransistor gebildet werden.

Im betrachteten Beispiel sind nur zwei Speicherzellen-Reihen SR1 und SR2, und vier Speicherzellen-Spalten SS1 bis SS4 dargestellt. In der Praxis sind üblicherweise jedoch sehr viel mehr Speicherzellen-Reihen und Speicherzellen-Spalten vorhanden.

Die Speichertransistoren sind mit den Bezugszeichen T11 bis T24 bezeichnet. Im betrachteten Beispiel handelt es sich um Feldeffekttransistoren mit einem Gate-Abschnitt, einem Drain-Abschnitt, einem Source-Abschnitt, und einem Floating Gate. Der Aufbau und die Wirkungsweise solcher Speichertransistoren sind bekannt, so daß auf eine nähere Beschreibung derselben verzichtet werden kann.

Die Source-Abschnitte aller Speichertransistoren sind über eine oder mehrere Source-Leitungen, welche in der Figur 1 nicht gezeigt sind, mit Masse verbunden. Die Drain-Abschnitte der Speichertransistoren jeweils einer Speicherzellen-Reihe sind über Bit-Leitungen BL1 und BL2 miteinander verbunden. Die Gate-Abschnitte der Speichertransistoren jeweils einer Speicherzellen-Spalte sind über Wortleitungen WL1 bis WL4 miteinander verbunden.

Wenn die Speichereinrichtung als integrierte Schaltung ausgebildet ist oder Bestandteil einer integrierten Schaltung ist,
- verlaufen die Source-Leitungen üblicherweise parallel zu den Wort-Leitungen und werden durch eine entsprechende Diffusion in dem die Speichereinrichtung tragenden Substrat gebildet (weil die Source-Leitungen dann besonders einfach und flächensparend herstellbar sind),
- verlaufen die Wortleitungen in der Poly-Schicht, und
- verlaufen die Bitleitungen in der Metall-Schicht.

Darüber hinaus enthält die in der Figur 1 gezeigte Anordnung einen Leseverstärker SA, welcher eingangsseitig mit einer der Bitleitungen BL1 und BL2 verbunden ist, und abwechselnd mit diesen Bitleitungen verbunden werden kann. Der Vollständigkeit halber sei angemerkt, daß auch für jede Bitleitung ein eigener Leseverstärker vorgesehen sein kann.

Wenn der Inhalt einer Speicherzelle bzw. des diese bildenden Speichertransistors programmiert, gelöscht oder ausgelesen werden soll, wird dieser Speichertransistor über die Wortleitung und die Bitleitung, mit welcher er verbunden ist, mit bestimmten Spannungen beaufschlagt.

Beim Programmieren und beim Löschen der Speichertransistoren sind diese Spannungen so gewählt, daß - beispielsweise durch Fowler Nordheim Tunneln - Ladungsträger auf das Floating Gate gelangen, oder auf dem Floating Gate vorhandene Ladungsträger abgezogen werden. Dadurch entsteht auf dem Floating Gate ein Ladungsträgerüberschuß oder ein Ladungsträgermangel, der nach dem Ende des Programmiervorganges oder des Löschvorganges erhalten bleibt, und entscheidend dafür ist, ob der Speichertransistor beim Auslesen desselben, genauer gesagt durch die hierbei an den Speichertransistor angelegten Spannungen in den leitenden Zustand oder in den nicht leitenden Zustand versetzt wird.

Beim Auslesen eines Speichertransistors sind die Spannungen so gewählt, daß der auszulesende Speichertransistor dadurch in den leitenden Zustand versetzt wird, wenn er eine "1" speichert, und daß der auszulesende Speichertransistor dadurch in den nicht leitenden Zustand versetzt wird, wenn er eine "0" speichert, oder umgekehrt. Während des Auslesens eines Speichertransistors fließt über die Bitleitung, mit welcher der gerade auszulesende Transistor verbunden ist, ein Strom, wobei abhängig von diesem Strom festgelegt wird, welchen Inhalt der gerade ausgelesene Speichertransistor hat. Genauer gesagt wird der über die Bitleitung fließende Strom durch den Leseverstärker SA in eine Spannung umgesetzt, in Abhängigkeit von welcher eine dem Leseverstärker SA nachgeschaltete Auswertungseinrichtung AE entscheidet, welchen Inhalt der auszulesende Speichertransistor hat.

Vorliegend interessiert insbesondere das Programmieren der Speichertransistoren.

Die Spannungen, die an den Speichertransistor angelegt werden müssen, um diesen zu programmieren, sind relativ hoch; zumindest muß die Differenz der Spannungen, die an den Gate-Abschnitt und an den Drain-Abschnitt eines zu programmierenden Speichertransistors angelegt werden, relativ groß sein, beispielsweise ca. 16 V. Dies kann beispielsweise dadurch bewerkstelligt werden, daß während des Programmierens an den Gate-Abschnitt des zu programmierenden Speichertransistors eine Spannung von -10 V angelegt wird, und an den Drain-Abschnitt eine Spannung von 6 V.

Die Verwendung solcher oder ähnlicher Gate- und Drainspannungen hat den negativen Effekt, daß der zu programmierende Speichertransistor während des Programmierens im nicht leitenden Zustand gehalten wird, wodurch sich eine relativ hohe Source-Drain-Spannung einstellt. Diese hohe Source-Drain-Spannung steht einer Verkleinerung der Speichertransistoren und damit auch des Flash-Speichers entgegen.

Zur Behebung dieses Nachteils könnte vorgesehen werden, den zu programmierenden Speichertransistor während des Programmierens in den leitenden Zustand zu versetzen. Dies wäre beispielsweise dadurch möglich, daß während des Programmierens an den Gate-Abschnitt des zu programmierenden Speichertransistors eine Spannung von 13 V angelegt wird, und an den Drain-Abschnitt des zu programmierenden Speichertransistors eine Spannung von -3 V, genauer gesagt, daß die mit dem Gate-Abschnitt des zu programmierenden Speichertransistors verbundene Wortleitung mit 13 V beaufschlagt wird, und die mit dem Drain-Abschnitt des zu programmierenden Speichertransistors verbundene Bitleitung mit -3 V beaufschlagt wird.

Gleichzeitig werden an die Gate- und Source-Abschnitte der nicht zu programmierenden Speichertransistoren Spannungen angelegt, durch welche bewirkt wird, daß die Gate-Drain-Spannungen dieser Speichertransistoren nicht groß genug sind, um diese Speichertransistoren zu programmieren. Dies ist beispielsweise dadurch möglich,
- daß an die Bitleitungen, die nicht mit dem zu programmierenden Speichertransistor verbunden sind, eine Spannung von +3 V angelegt wird, und
- daß an die Wortleitungen, die nicht mit dem zu programmierenden Speichertransistor verbunden sind, keine Spannung oder eine kleine Spannung, beispielsweise 0 V angelegt wird.

Die Verwendung solcher oder ähnlicher Gate- und Drainspannungen hat den positiven Effekt, daß die Source-Drain-Spannungen sowohl der zu programmierenden Speichertransistoren als auch der nicht zu programmierenden Speichertransistoren sehr klein, teilweise sogar gleich 0 sind, wodurch die Speichertransistoren kleiner ausgebildet werden können.

Bei der Verwendung derartiger Gate- und Drainspannungen treten jedoch andere Nachteile auf. Diese Nachteile bestehen darin, daß die Drain-Spannungen der während des Programmierens im leitenden Zustand befindlichen Transistoren, d.h. die Drain-Spannungen der Transistoren, die mit der Wortleitung verbunden sind, mit welcher auch der zu programmierende Speichertransistor verbunden ist, kurzgeschlossen werden würden.

Ein Kurzschluß zwischen den verschiedenen Drain-Spannungen kann aufgrund der dadurch veränderten Gate-Drain-Spannungen zur Folge haben, daß der zu programmierende Speichertransistor nicht programmiert wird, und/oder daß einer, mehrere, oder alle der nicht zu programmierenden Speichertransistoren doch programmiert werden.

Der Kurzschluß der verschiedenen Drain-Spannungen kommt dadurch zustande, daß, wie vorstehend bereits erwähnt wurde, üblicherweise die Source-Abschnitte aller Speichertransistoren, die mit einer Wortleitung verbunden sind, über eine parallel zur Wortleitung verlaufende gemeinsame Sourceleitung miteinander verbunden sind.

Der Kurzschluß der Drain-Spannungen könnte verhindert werden, indem die Source-Abschnitte der Speichertransistoren die mit der selben Wortleitung verbunden sind, nicht miteinander verbunden werden. Dies könnte beispielsweise dadurch geschehen, daß die Sourceleitungen jeweils parallel zu den Bitleitungen verlaufen, und jeweils die Source-Anschlüsse der Speichertransistoren einer Speicherzellen-Reihe miteinander verbinden. Allerdings sind so verlaufende Sourceleitungen weniger einfach herstellbar und führen darüber hinaus zu einer Vergrößerung der Speichereinrichtung.

Eine andere Möglichkeit zur Verhinderung des Kurzschlusses der Drain-Spannungen besteht darin, daß für jede Speicherzelle ein zusätzlicher Auswahltransistor vorgesehen wird, welcher in Reihe zu dem jeweiligen Speichertransistor geschaltet ist. Auch diese Lösung führt jedoch zu einer deutlichen Vergrößerung der Speichereinrichtung.

WO 01/67517 beschreibt einen Feldeffekttransistor mit zwei Gate-Abschnitten und einen Floating-Gate.

Der vorliegenden Erfindung liegt daher die Aufgabe zugrunde, eine Möglichkeit zu finden, durch welche sich Speichereinrichtungen und sonstige Transistoren enthaltende Einrichtungen verkleinern lassen.

Diese Aufgabe wird erfindungsgemäß durch den in Patentanspruch 1 beanspruchten Feldeffekttransistor gelöst.

Der erfindungsgemäße Feldeffekttransistor zeichnet sich dadurch aus, daß er einen zweiten Gate-Abschnitt aufweist, wobei die Gate-Abschnitte so angeordnet sind, daß sie auf benachbarte Teile des zwischen dem Source-Abschnitt und dem Drain-Abschnitt liegenden Bereiches wirken.

Wenn man
- die zwei Gate-Abschnitte so anordnet, daß ein erster Teil des leitenden Kanals, der sich im leitenden Zustand des Feldeffekttransistors zwischen dem Source-Abschnitt und dem Drain-Abschnitt desselben bildet, nur durch den ersten Gate-Abschnitt in den leitenden Zustand versetzbar ist, und ein zweiter Teil dieses Kanals nur durch den zweiten Gate-Abschnitt in den leitenden Zustand versetzbar ist, und
- ferner dafür sorgt, daß der Kanal nur leitend ist, wenn beide Kanalteile leitend sind, und daß der Kanal nicht leitend ist, wenn nur ein Kanalteil oder keiner der Kanalteile leitend ist,
so kann der Feldeffekttransistor zwei in Reihe geschaltete Transistoren ersetzen.

Der beanspruchte Feldeffekttransistor ist einfach und erheblich kleiner herstellbar als zwei in Reihe geschaltete Transistoren und ermöglicht die Verkleinerung beliebiger Schaltungen, die in Reihe geschaltete Transistoren enthalten.

Der beanspruchte Feldeffekttransistor kann auch als Ersatz für eine Reihenschaltung eines Speichertransistors und eines Auswahltransistors verwendet werden. In diesem Fall kann der Speichertransistor ohne Vorsehen eines separaten Auswahltransistors, und ohne eine geänderte Führung der Sourceleitungen unter Verwendung beliebiger Gate- und Drain-Spannungen, insbesondere unter Verwendung solcher Gate- und Drain-Spannungen programmiert werden, durch welche sich minimale Source-Drain-Spannungen einstellen. Kleine Source-Drain-Spannungen haben den positiven Effekt, daß der Transistor sehr klein realisiert werden kann. Genauer gesagt kann der beanspruchte Feldeffekttransistor trotz des zusätzlichen Gate-Abschnittes kleiner realisiert werden als üblicherweise in Speichereinrichtungen verwendete Speichertransistoren.

Der beanspruchte Feldeffekttransistor bietet nach alledem die Möglichkeit, Speichereinrichtungen und sonstige Transistoren enthaltende Einrichtungen mit geringem Aufwand zu verkleinern.

Vorteilhafte Weiterbildungen der Erfindung sind den Unteransprüchen, der folgenden Beschreibung, und den Figuren entnehmbar.

Die Erfindung wird nachfolgend anhand eines Ausführungsbeispiels unter Bezugnahme auf die Figuren näher erläutert. Es zeigen
- Figur 1: den Aufbau eines Flash-Speichers,
- Figur 2: den Aufbau eines im Flash-Speicher gemäß Figur 1 verwendeten Speichertransistors, und
- Figur 3: den Aufbau des nachfolgend näher beschriebenen Feldeffekttransistors.

Der im folgenden näher beschriebene Transistor ist ein modifizierter Speichertransistor eines Flash-Speichers. Die Besonderheiten des beschriebenen Transistors lassen sich aber auch bei anders aufgebauten und/oder anders betriebenen Speichertransistoren, und auch bei normalen, d.h. keine Speichertransistoren darstellenden Transistoren verwenden.

Transistoren, welche die Besonderheiten des nachfolgend beschriebenen Transistoren aufweisen, lassen sich nicht nur in Speichereinrichtungen einsetzen, sondern auch in beliebigen anderen Einrichtungen.

Der beschriebene Transistor ist ein in einer integrierten Schaltung enthaltener Feldeffekttransistor. Genauer gesagt handelt es sich, wie vorstehend bereits erwähnt wurde, um einen modifizierten Speichertransistor eines Flash-Speichers. Der beschriebene Transistor ist dazu ausgelegt die Speichertransistoren eines Flash-Speichers, beispielsweise die Speichertransistoren T11 bis T24 des in der Figur 1 gezeigten und unter Bezugnahme darauf beschriebenen Flash-Speichers zu ersetzen. Der prinzipielle Aufbau des Flash-Speichers ändert sich dadurch nicht. Es werden "nur" andere Transistoren verwendet. Sofern sich aus der folgenden Beschreibung des hier vorgestellten Transistors nichts Gegenteiliges ergibt, gelten die zu Figur 1 gemachten Ausführungen auch für einen die nachfolgend beschriebenen Transistoren enthaltenden Flash-Speicher.

Bevor mit der Beschreibung des hier vorgestellten Transistors begonnen wird, wird zunächst der Aufbau eines "normalen" Speichertransistors beschrieben. Der Aufbau eines solchen Speichertransistors ist in Figur 2 veranschaulicht.

Der Speichertransistor enthält einen Source-Abschnitt SS, einen Drain-Abschnitt DS, einen Gate-Abschnitt GS, sowie ein Floating Gate FGS,
- wobei der Source-Abschnitt SS und der Drain-Abschnitt DS durch stark n-dotierte Bereiche innerhalb eines im allgemeinen durch ein Silizium-Plättchen gebildeten Substrats SUB gebildet werden, genauer gesagt durch n-dotierte Bereiche innerhalb einer p-dotierten p-Wanne PW, welche ihrerseits wiederum in einer n-dotierten n-Wanne NW liegt,
- wobei das Floating Gate FGS durch eine oberhalb des Substrats SUB vorgesehene, im allgemeinen aus Poly-Silizium bestehende Poly-Schicht gebildet wird, und
- wobei der Gate-Abschnitt GS durch eine oberhalb des Floating Gate vorgesehene zweite, ebenfalls aus Poly-Silizium bestehende Poly-Schicht gebildet wird.

Der Vollständigkeit halber sei angemerkt,
- daß nicht nur der gezeigte Speichertransistor, sondern das gesamte Speicherzellenfeld der in der Figur 1 gezeigten Anordnung in der p-Wanne PW liegt, und
- daß die p-Wanne PW in einer n-Wanne NW liegt, weil an die p-Wanne eine negative Spannung angelegt wird, um zu verhindern, daß bei negativer Bitleitungsspannung eine Vorwärtspolung der Drain-Diode erfolgt.

Im Gegensatz hierzu weist der hier vorgestellte Transistor den in Figur 3 gezeigten Aufbau auf.

Dieser Transistor enthält wie der in der Figur 2 gezeigte Speichertransistor einen Drain-Abschnitt DS, einen Gate-Abschnitt GS, sowie ein Floating Gate FGS, wobei diese Komponenten wie bei dem in der Figur 2 gezeigten Speichertransistor ausgebildet und angeordnet sind.

Auch die Wannenstruktur ist gleich. D.h., der hier vorgestellte Transistor, ist ebenfalls in einer p-Wanne PW untergebracht, welche ihrerseits wiederum in einer n-Wanne NW liegt. Die p-Wanne PW kann den in der Figur 3 gezeigten Transistor allein oder zusätzlich beliebige weitere Schaltungsteile, beispielsweise das gesamte Speicherzellenfeld oder den gesamten Flash-Speicher enthalten.

Der hier vorgestellte Transistor weist jedoch keinen Source-Abschnitt SS auf, der wie beim Speichertransistor gemäß Figur 2 ausgebildet und angeordnet ist.

Er weist dafür aber einen Kanalimplantationsabschnitt KJ, einen zweiten Gate-Abschnitt GJ, sowie einen Source-Abschnitt SJ auf,
- wobei der Kanalimplantationsabschnitt KJ durch einen schwach n-dotierten Bereich innerhalb der p-Wanne PW gebildet wird, und dort vorgesehen ist, wo sich bei dem in der Figur 2 gezeigten Speichertransistor der Source-Abschnitt desselben befindet,
- wobei der Source-Abschnitt SJ durch einen stark n-dotierten Bereich innerhalb der p-Wanne PW gebildet wird, und benachbart zum Kanalimplantationsabschnitt KJ angeordnet ist, und
- wobei der zweite Gate-Abschnitt GJ durch einen unterhalb des Kanalimplantationsabschnittes KJ vorgesehenen stark p-dotierten (stärker als die p-Wanne PW dotierten) Bereich innerhalb der p-Wanne PW gebildet wird.

Der Source-Abschnitt SJ ist mit einer der Source-Leitungen des Flash-Speichers verbunden, der Drain-Abschnitt DS mit einer der Bit-Leitungen BL, und der erste Gate-Abschnitt GS mit einer der Wortleitungen WL.

Der zweite Gate-Abschnitt GJ wird über die p-Wanne PW mit der gewünschten Spannung beaufschlagt.

Der Transistor wird durch die zwei Gate-Abschnitte GS und GJ gesteuert. Genau genommen auch noch über das Floating Gate FGS, wobei das Floating Gate jedoch nur eine stark eingeschränkte Steuerfunktion hat,
- weil es "nur" auf die Thresholdspannung, d.h. auf die Bedingungen Einfluß nimmt, die die Spannungen am ersten Gate-Abschnitt GS, am Drain-Abschnitt DS, und im Kanalimplantationsabschnitt KJ erfüllen müssen, damit sich zwischen dem Kanalimplantationsabschnitt KJ und dem Drain-Abschnitt DS ein leitender Kanal bildet, und
- weil es selbst nur durch die an den ersten Gate-Abschnitt GS angelegte Spannung gesteuert wird.

Wenn den den Transistoren steuernden Gate-Abschnitten GS und GJ Spannungen zugeführt werden, die ausreichend groß oder ausreichend klein sind, kommt der Transistor in den leitenden Zustand. Im leitenden Zustand existiert zwischen dem Source-Abschnitt SJ und dem Drain-Abschnitt DS ein durchgehender leitender Kanal, über welchen zwischen dem Source-Abschnitt SJ und dem Drain-Abschnitt DS ein Strom fließen kann.

Dieser leitende Kanal setzt sich aus zwei Teilen zusammen, nämlich aus Kanalimplantationsabschnitt KJ, und dem unter dem Floating Gate FGS befindlichen Substratabschnitt.

Der durch den Kanalimplantationsabschnitt KJ gebildete Kanalteil wird durch den Gate-Abschnitt GJ in den leitenden bzw. nicht leitenden Zustand versetzt; der Kanalteil, der sich in dem unter dem Floating Gate FGS befindlichen Substratabschnitt bilden kann, wird durch den ersten Gate-Abschnitt GS gesteuert.

Der in der Figur 3 gezeigte Transistor kann auch als besonders effiziente Reihenschaltung zweier Transistoren angesehen werden, genauer gesagt als Reihenschaltung eines MOSFET und eines JFET,
- wobei der erste Gate-Abschnitt GS, das Floating Gate FGS, und der Drain-Abschnitt DS zum MOSFET gehören,
- wobei der Gate-Abschnitt GJ und der Kanalimplantationsabschnitt KJ zum JFET gehören,
- wobei der MOSFET keinen Source-Abschnitt aufweist (als Source wird der Kanalimplantationsabschnitt KJ des JFET verwendet), und
- wobei der JFET keinen Drain-Abschnitt aufweist.

Von den zwei Transistoren entspricht der MOSFET einem Speichertransistor, und der JFET einem Auswahltransistor.

Der Auswahltransistor wird über die an die p-Wanne PW angelegte Spannung so angesteuert, daß er sich während des Programmierens des Speichertransistors im nicht leitenden Zustand befindet, und ansonsten im leitenden Zustand. Daß sich der Auswahltransistor während des Programmierens des Speichertransistors im nicht leitenden Zustand befindet, hat den positiven Effekt, daß die den Drain-Anschlüssen der Speichertransistoren einer Speicherzellenfeldes über die Bitleitungen zugeführten Spannungen nicht über die miteinander verbundenen Source-Anschlüsse kurzgeschlossen werden können. Dies wiederum ermöglicht es, die Spannungen, die einem Speichertransistor während des Programmierens desselben zugeführt werden, frei zu wählen. Die Spannungen können insbesondere so gewählt werden, daß sich sowohl an dem zu programmierenden Speichertransistor als auch an den nicht zu programmierenden Speichertransistoren geringe Source-Drain-Spannungen einstellen. Dies hat, wie eingangs bereits erwähnt wurde, den positiven Effekt, daß die Speichertransistoren ohne größere Schwierigkeiten verkleinert werden können.

Im betrachteten Beispiel sind die Spannungen, die an den Speichertransistor während des Programmierens desselben angelegt werden, wie folgt gewählt:
- die Spannung, mit welcher Wortleitung WL beaufschlagt wird, die mit dem Gate-Abschnitt GS des zu programmierenden Speichertransistors verbunden ist, beträgt 13 V,
- die Spannung, mit welcher die Bitleitung BL beaufschlagt wird, die mit dem Drain-Abschnitt DS des zu programmierenden Speichertransistors verbunden ist, beträgt -3 V,
- die Spannung, mit welcher die Wortleitungen WL beaufschlagt werden, die nicht mit dem Gate-Abschnitt GS des zu programmierenden Speichertransistors verbunden ist, beträgt 0 V, und
- die Spannung, mit welcher die Bitleitungen BL beaufschlagt werden, die nicht mit dem Drain-Abschnitt DS des zu programmierenden Speichertransistors verbunden sind, beträgt +3 V.

Der Vollständigkeit halber sei angemerkt, daß keine Einschränkung darauf besteht, genau diese Spannungen zu verwenden. Die durch die spezielle Spannungswahl angestrebten Vorteile lassen sich zumindest teilweise auch erzielen, wenn mehr oder weniger stark veränderte Spannungen verwendet werden.

Das Sperren des Auswahltransistors kann dadurch bewerkstelligt werden, daß an die p-Wanne PW eine Spannung angelegt wird, die bei der während des Programmierens verwendeten negativen Bitleitungsspannung ein Sperren des Auswahltransistors bewirkt. Diese Spannung beträgt im betrachteten Beispiel -5 V.

Zu Zeiten außerhalb des Programmierens des Speichertransistors beträgt die an die p-Wanne PW angelegte Spannung beispielsweise 0 V. Dadurch befindet sich der Auswahltransistor im leitenden Zustand.

Der hier vorgestellte und unter Bezugnahme auf die Figur 3 beschriebene Transistor läßt sich einfach und vor allem erheblich kleiner realisieren als eine Reihenschaltung aus einem Speichertransistor und einem separaten Auswahltransistor, ja sogar kleiner als ein herkömmlicher Speichertransistor alleine.

Es dürfte einleuchten und bedarf keiner näheren Erläuterung, daß das Floating Gate FGS des beschriebenen Transistors weggelassen werden kann, und daß ein solcher Transistor nicht nur in Speichereinrichtungen, sondern auch in beliebigen anderen Einrichtungen zum Einsatz kommen kann.

Der beschriebene Feldeffekttransistor ermöglicht es unabhängig von den Einzelheiten der praktischen Realisierung, Speichereinrichtungen und sonstige Transistoren enthaltende Einrichtungen mit geringem Aufwand zu verkleinern.

### Bezugszeichenliste

- AE: Auswertungseinrichtung
- BLx: Bitleitung
- DS: Drain-Abschnitt
- FGS: Floating Gate
- GJ: Gate-Abschnitt
- GS: Gate-Abschnitt
- KJ: Kanalimplantationsabschnitt
- NW: n-Wanne
- PW: p-Wanne
- SA: Leseverstärker
- SJ: Source-Abschnitt
- SRx: Speicherzellen-Reihe
- SS: Source-Abschnitt
- SSx: Speicherzellen-Spalte
- SUB: Substrat
- Tx: Speichertransistor
- WLx: Wortleitung

## Patentansprüche

1. Feldeffekttransistor mit einem Source-Abschnitt (SJ), einem Drain-Abschnitt (DS), einem Gate-Abschnitt (GS), und einem zweiten Gate-Abschnitt (GJ), wobei die Gate-Abschnitte (GS, GJ) so angeordnet sind, daß sie auf benachbarte Teile des zwischen dem Source-Abschnitt (SJ) und dem Drain-Abschnitt (DS) liegenden Bereiches wirken,
**dadurch gekennzeichnet,**
**daß** der Drain-Abschnitt (DS) und der erste Gate-Abschnitt (GS) des Feldeffekttransistors so ausgebildet und angeordnet sind wie die entsprechenden Komponenten eines MOSFET,
**daß** der Source-Abschnitt (SJ), der zweite Gate-Abschnitt (GJ), und der von diesem gesteuerte Kanalteil so ausgebildet sind wie die entsprechenden Komponenten eines JFET,
**daß** der Feldeffekttransistor einer Reihenschaltung eines keinen Source-Anschluß aufweisenden MOSFET und eines keinen Drain-Anschluß aufweisenden JFET entspricht, und
**daß** der MOSFET der MOSFET-JFET-Reihenschaltung ein Floating Gate (FGS) aufweist und als Speichertransistor verwendet wird.

2. Feldeffekttransistor nach Anspruch 1,
**dadurch gekennzeichnet,**
**daß** der Feldeffekttransistor Bestandteil einer integrierten Schaltung ist.

3. Feldeffekttransistor nach Anspruch 1 oder 2,
**dadurch gekennzeichnet,**
**daß** der Feldeffekttransistor so ausgebildet ist, daß der Source-Abschnitt (SJ) desselben und der Drain-Abschnitt (DS) desselben im leitenden Zustand des Feldeffekttransistors über einen elektrisch leitenden Kanal miteinander verbunden sind, wobei der Kanal einen ersten Kanalteil und einen zweiten Kanalteil aufweist, und wobei der Kanal nur leitend ist, wenn beide Kanalteile leitend sind, und der Kanal nicht leitend ist, wenn nur einer oder keiner der Kanalteile leitend ist.

4. Feldeffekttransistor nach Anspruch 3,
**dadurch gekennzeichnet,**
**daß** der erste Kanalteil nur durch den ersten Gate-Abschnitt (GS) in den leitenden Zustand versetzbar ist, und der andere Kanalteil nur durch den zweiten Gate-Abschnitt (GJ) in den leitenden Zustand versetzbar ist.

5. Feldeffekttransistor nach einem der vorhergehenden Ansprüche,
**dadurch gekennzeichnet,**
**daß** der zweite Gate-Abschnitt (GJ) unterhalb des von diesem gesteuerten Kanalteils liegt.

6. Feldeffekttransistor nach einem der vorhergehenden Ansprüche,
**dadurch gekennzeichnet,**
**daß** der zweite Gate-Abschnitt (GJ) keine eigene Anschlußvorrichtung aufweist, über welche ihm die an ihn anzulegende Steuerspannung zuführbar ist.

7. Feldeffekttransistor nach Anspruch 6,
**dadurch gekennzeichnet,**
**daß** der zweite Gate-Abschnitt (GJ) in eine durch ein bestimmtes Halbleiter-Material gebildete Wanne (PW) eingebettet ist, und daß der zweite Gate-Abschnitt (GJ) und die ihn enthaltende Wanne (PW) so ausgebildet sind, daß der zweite Gate-Abschnitt (GJ) durch die Wanne (PW) auf das Potential gebracht wird, auf welches diese durch eine an sie angelegte Spannung gebracht wird.

8. Feldeffekttransistor nach einem der vorhergehenden Ansprüche,
**dadurch gekennzeichnet,**
**daß** der JFET der MOSFET-JFET-Reihenschaltung als Auswahltransistor verwendet wird.

9. Feldeffekttransistor nach einem der vorhergehenden Ansprüche,
**dadurch gekennzeichnet,**
**daß** der als Auswahltransistor verwendete Teil des Feldeffekttransistors so betrieben wird, daß er während des Programmierens des als Speichertransistor verwendeten Teils des Feldeffekttransistors in den nicht leitenden Zustand versetzt wird.

10. Feldeffekttransistor nach einem der vorhergehenden Ansprüche,
**dadurch gekennzeichnet,**
**daß** der Source-Anschluß (SJ) des Feldeffekttransistors mit dem Source-Anschluß eines zweiten Feldeffekttransistors verbunden ist, und daß der als Auswahltransistor verwendete Teil des Feldeffekttransistors so betrieben wird, daß er während des Programmierens des zweiten Feldeffekttransistors in den nicht leitenden Zustand versetzt wird.

11. Feldeffekttransistor nach einem der vorhergehenden Ansprüche,
**dadurch gekennzeichnet,**
**daß** der als Speichertransistor verwendete Teil des Feldeffekttransistors während des Programmierens desselben so angesteuert wird, daß sich der als Speichertransistor verwendete Teil des Feldeffekttransistors während des Programmierens desselben im leitenden Zustand befindet.

## Claims

1. Field effect transistor comprising a source section (SJ), a drain section (DS), a gate section (GS), and a second gate section (GJ), wherein the gate sections (GS, GJ) are arranged such that they act on adjacent parts of the region lying between the source section (SJ) and the drain section (DS),
**characterized**
**in that** the drain section (DS) and the first gate section (GS) of the field effect transistor are embodied and arranged like the corresponding components of a MOSFET,
**in that** the source section (SJ), the second gate section (GJ), and the channel part controlled by the latter are embodied like the corresponding components of a JFET,
**in that** the field effect transistor corresponds to a series circuit formed by a MOSFET having no source terminal and a JFET having no drain terminal, and
**in that** the MOSFET of the MOSFET-JFET series circuit has floating gate (FGS) and is used as a memory transistor.

2. Field effect transistor according to Claim 1,
**characterized**
**in that** the field effect transistor is part of an integrated circuit.

3. Field effect transistor according to Claim 1 or 2,
**characterized**
**in that** the field effect transistor is embodied such that the source section (SJ) thereof and the drain section (DS) thereof, in the on state of the field effect transistor, are connected to one another via an electrically conducting channel, wherein the channel has a first channel part and second channel part, and wherein the channel is only conducting if both channel parts are conducting, and the channel is not conducting if only one or none of the channel parts is conducting.

4. Field effect transistor according to Claim 3,
**characterized**
**in that** the first channel part can be put into the conducting state only by the first gate section (GS), and the other channel part can be put into the conducting state only by the second gate section (GJ).

5. Field effect transistor according to any of the preceding claims,
**characterized**
**in that** the second gate section (GJ) lies below the channel part controlled by it.

6. Field effect transistor according to any of the preceding claims,
**characterized**
**in that** the second gate section (GJ) has no dedicated terminal device via which the control voltage to be applied to it can be fed to it.

7. Field effect transistor according to Claim 6,
**characterized**
**in that** the second gate section (GJ) is embedded in a well (PW) formed by a specific semiconductor material, and in that the second gate section (GJ) and the well (PW) containing it are embodied such that the second gate section (GJ) is brought by the well (PW) to the potential to which the latter is brought by a voltage applied thereto.

8. Field effect transistor according to any of the preceding claims,
**characterized**
**in that** the JFET of the MOSFET-JFET series circuit is used as a selection transistor.

9. Field effect transistor according to any of the preceding claims,
**characterized**
**in that** that part of the field effect transistor which is used as a selection transistor is operated such that it is put into the non-conducting state during the programming of that part of the field effect transistor which is used as the memory transistor.

10. Field effect transistor according to any of the preceding claims,
**characterized**
**in that** the source terminal (SJ) of the field effect transistor is connected to the source terminal of a second field effect transistor, and in that that part of the field effect transistor which is used as a selection transistor is operated such that it is put into the non-conducting state during the programming of the second field effect transistor.

11. Field effect transistor according to any of the preceding claims,
**characterized**
**in that** that part of the field effect transistor which is used as a memory transistor is driven during the programming thereof such that that part of the field effect transistor which is used as a memory transistor is in the conducting state during the programming thereof.

## Revendications

1. Transistor à effet de champ doté d'une partie de source (SJ), d'une partie de drain (DS), d'une partie de grille (GS) et d'une deuxième partie de grille (GJ),
les parties de grille (GS, GJ) étant disposées de telle sorte qu'elles agissent sur des segments voisins de la zone située entre la partie de source (SJ) et la partie de drain (DS),
**caractérisé en ce que**
la partie de drain (DS) et la première partie de grille (GS) du transistor à effet de champ sont configurées et disposées de la même manière que les composants correspondants d'un MOSFET,
**en ce que** la partie de source (SJ), la deuxième partie de grille (GJ) et le segment de canal qu'elles commandent sont configurés de la même manière que les composants correspondants d'un JFET,
**en ce que** le transistor à effet de champ correspond au raccordement en série d'un MOSFET ne présentant pas de borne de source et d'un JFET ne présentant pas de borne de drain et
**en ce que** le MOSFET du circuit en série MOSFET-JFET présente une grille flottante (FGS) et est utilisé comme transistor de mémoire.

2. Transistor à effet de champ selon la revendication 1, **caractérisé en ce que** le transistor à effet de champ fait partie d'un circuit intégré.

3. Transistor à effet de champ selon les revendications 1 ou 2, **caractérisé en ce que** le transistor à effet de champ est configuré de telle sorte que sa partie de source (SJ) et sa partie de drain (DS) sont reliées l'une à l'autre par un canal électriquement conducteur lorsque le transistor à effet de champ est à l'état conducteur, le canal présentant un premier segment de canal et un deuxième segment de canal, le canal n'étant conducteur que si les deux segments de canaux sont conducteurs, les canaux n'étant pas conducteurs lorsque seul un des segments de canal ou aucun des segments de canal ne sont conducteurs.

4. Transistor à effet de champ selon la revendication 3, **caractérisé en ce que** le premier segment de canal ne peut être amené à l'état conducteur que par la première partie de grille (GS), l'autre segment de canal ne pouvant être amené à l'état conducteur que par la deuxième partie de grille (GJ).

5. Transistor à effet de champ selon l'une des revendications précédentes, **caractérisé en ce que** la deuxième partie de grille (GJ) est située en dessous du segment de canal qu'elle commande.

6. Transistor à effet de champ selon l'une des revendications précédentes, **caractérisé en ce que** la deuxième partie de grille (GJ) ne présente pas de dispositif de raccordement propre par lequel une tension de commande qui doit lui être appliquée peut lui être amenée.

7. Transistor à effet de champ selon la revendication 6, **caractérisé en ce que** la deuxième partie de grille (GJ) est incorporée dans une cuvette (PW) formée par un matériau semiconducteur défini et **en ce que** la deuxième partie de grille (GJ) et la cuvette (PW) qui la contient sont configurées de telle sorte que la deuxième partie de grille (GJ) est amenée par la cuvette (PW) au potentiel auquel la partie de grille est amenée lorsqu'une tension lui est appliquée.

8. Transistor à effet de champ selon l'une des revendications précédentes, **caractérisé en ce que en ce que** le JFET du circuit série MOSFET-JFET est utilisé comme transistor de sélection.

9. Transistor à effet de champ selon l'une des revendications précédentes, **caractérisé en ce que** la partie du transistor à effet de champ utilisée comme transistor de sélection est utilisée de telle sorte qu'elle est amenée à l'état non conducteur pendant la programmation de la partie du transistor à effet de champ utilisée comme transistor de mémoire.

10. Transistor à effet de champ selon l'une des revendications précédentes, **caractérisé en ce que** la borne de source (SJ) du transistor à effet de champ est reliée à la borne d'un deuxième transistor à effet de champ et **en ce que** la partie du transistor à effet de champ utilisée comme transistor de sélection est utilisée de telle sorte qu'elle est amenée à l'état non conducteur pendant la programmation du deuxième transistor à effet de champ.

11. Transistor à effet de champ selon l'une des revendications précédentes, **caractérisé en ce que** la partie du transistor à effet de champ utilisée comme transistor de mémoire est commandée pendant sa programmation de telle sorte que la partie du transistor à effet de champ utilisée comme transistor de mémoire se trouve à l'état conducteur pendant la programmation du transistor à effet de champ.
